# FASCICULE DE BREVET EUROPEEN

(11) **EP 2 953 433 B1**
(45) Date de publication et mention de la délivrance du brevet: **16.10.2024**
(21) Numéro de dépôt: 15170107.5
(22) Date de dépôt: 01.06.2015
(51) Int. Cl.: H05K 1/02, H05K 1/09, H05K 3/12

(54) **PROCEDE DE FABRICATION D'UN COMPOSANT ELECTRIQUE CONFIGURABLE**
HERSTELLUNGSVERFAHREN EINER KONFIGURIERBAREN ELEKTRISCHEN KOMPONENTE
METHOD FOR MANUFACTURING A CONFIGURABLE ELECTRICAL COMPONENT

(30) Priorité: 02.06.2014 FR 1454989
(43) Date de publication de la demande: 09.12.2015
(73) Titulaire: IDEMIA France, 92400 Courbevoie (FR)
(72) Inventeur: Ali, Ahmed, 92700 Colombes (FR)
(74) Mandataire: Idemia

(56) Documents cités:
- FR-A1- 2 938 096
- JP-A- 2011 040 811
- US-A1- 2009 128 290
- US-A1- 2009 274 833

## Description

### Arrière-plan de l'invention

La présente invention se situe dans le domaine des procédés de frittage. L'invention vise plus particulièrement une méthode de fabrication d'un composant électrique dans laquelle on impose, à tout ou partie d'un motif imprimé sur un substrat, une opération de frittage de manière à modifier l'état des particules conductrices pour former une liaison électriquement conductrice.

Le document US2009128290 A1 décrit une antenne imprimée hybride unique individuellement pour des applications RFID sans puce, et divulgue également le préambule de la revendication 1.

De façon connue, les procédés de frittage, peuvent être réalisés en exposant le motif imprimé à de la chaleur (frittage thermique), à une lumière intense, à une radiation microondes, à du plasma, à une tension électrique, ou à un agent chimique.

De nombreux développements ont été menés pour proposer des procédés de frittage dans lesquels on cherche à éviter la détérioration du substrat par la chaleur, en particulier pour les substrats polymères, de type PET ou polycarbonates.

Pour la fabrication de produits multi-couches, il est usuel, après l'étape de frittage, dans laquelle seule une partie du motif imprimé a été rendue conductrice, d'effectuer une opération de laminage.

Malheureusement, il est fréquent que cette opération de laminage vienne rendre conductrices des parties du motif qui devraient rester non conductrices.

L'invention vise un procédé de fabrication d'un composant électrique qui ne présente pas un tel inconvénient. Elle s'applique de façon privilégiée mais non limitative dans le domaine de la fabrication des cartes à puce.

### Objet et résumé de l'invention

Plus précisément, l'invention concerne un procédé de fabrication d'un composant électrique configurable selon la revendication 1 et comportant une étape d'impression d'un motif sur un substrat avec une nano-encre à base de nanoparticules conductrices, ce motif étant interrompu par au moins une micro-coupure en vue de fournir le caractère configurable souhaité.

Dans le mode de réalisation du procédé selon l'invention, cette encre est une nano-encre non conductrice initialement (autrement dit au dépôt), à base de nanoparticules conductrices portées par un matériau non conducteur appelé véhicule.

Le composant est dit reconfigurable en ce que son comportement électrique dépend d'une étape ultérieure de frittage pour rendre tout ou partie du motif conductrice.

On entend par frittage, le procédé qui consiste à chauffer ou cuire l'encre à nanoparticules, initialement peu ou pas conductrice, de sorte à modifier l'état de ces particules. La matière non conductrice portant les nanoparticules conductrices, que l'on appelle véhicule, est chassée par l'énergie qui lui est couplée par le procédé de frittage, appliquée en adéquation avec la nature de cette matière ainsi que celle des nanoparticules (en taille et matière), laissant donc sa place aux nanoparticules. Ces dernières se soudent entre elles pour former la cohésion de la piste imprimée et l'amener à un état conducteur. Les particules sont agglutinées entre elles, puis liées entre elles, par le changement d'état.

Le procédé selon l'invention comporte en outre une étape de frittage d'au moins une partie dudit motif de manière à rendre cette partie conductrice, l'étape de frittage permettant de modifier l'état des nanoparticules comprises dans la nano-encre de manière à remplir au moins partiellement les micro-coupures.

L'invention peut être utilisée pour fabriquer un composant radiofréquence à caractère configurable, comme à titre d'exemple, la fréquence de résonance pour une antenne imprimée, la bande passante d'un filtre ou bien l'impédance d'un dipôle passif imprimé, tel qu'une résistance, une capacité ou une inductance.

Par conséquent, dans un mode particulier de réalisation, l'invention vise un procédé de fabrication d'une antenne à capacité configurable, ce procédé comportant :
- une étape de placement sur le substrat d'une antenne, d'un réseau relié à ladite antenne, et d'au moins deux condensateurs en plaques; et
- une étape d'impression du motif avec la nano-encre non conductrice d'une liaison entre chacune des plaques et le réseau, cette liaison comportant au moins une micro-coupure.

La capacité de l'antenne peut ainsi être configurée en fonction du nombre et de la position des plaques reliées électriquement à l'antenne via le réseau.

La durée de l'opération de frittage est suffisamment courte pour ne pas endommager le substrat.

Les nano-encres sont en effet connues pour être de très mauvais conducteurs électriques au dépôt et pour devenir conductrices après avoir été soumises à une opération de frittage bref et intense (« flash sintering » en anglais). L'opération de frittage, réalisée en général par des impulsions d'énergie photonique, réglées en nombre, intensité et durée pour s'adapter à chaque type d'encre (véhicule et nanoparticules) et support. L'homme du métier peut sur ce sujet se reporter au document de Hak-Sung Kim, Sanjay R. Dhage, Dong-Eon Shim et H. Thomas Hanh « Intense pulse light sintering of copper nanoink for printed electronics », Appl. Phys A (2009) 97 :791-798 DOI.07/s00339-009-5360-6.

Les nano-encres peuvent être imprimées par une technique de jet d'encre ou de sérigraphie, l'impression jet d'encre permettant d'obtenir une meilleure précision pour l'implantation (dimensions X, Y) et l'épaisseur (dimension Z) du circuit. En effet, il est possible d'imprimer à une précision de 10µm, voire de 1µm en procédé optimisé, selon les machines d'impression utilisées.

Dans le mode de réalisation du procédé selon l'invention, ladite au moins une micro-coupure présente une largeur comprise entre 10µm et 50µm.

Ces micro-coupures permettent de garantir que les liaisons qui doivent demeurer non-conductrices restent effectivement non-conductrices même après avoir subi une opération de séchage ou de laminage.

En effet, dans un mode particulier de réalisation, le procédé de fabrication selon l'invention comporte entre l'impression des liaisons et l'étape de frittage, une étape de séchage pour stabiliser la nano-encre.

Conformément à l'invention, les liaisons imprimées non conductrices entre les condensateurs à plaque et le réseau comportent ainsi des micro-coupures telles que ces liaisons imprimées demeurent non-conductrices même après l'étape de séchage visant à stabiliser la nano-encre après impression.

Dans ce mode de réalisation, l'étape de séchage mise en oeuvre pour stabiliser la nano-encre est réalisée à un niveau de température suffisamment bas pour ne pas modifier l'état des micro-particules.

En revanche, les caractéristiques du procédé de frittage, en particulier le nombre d'impulsions, la durée/fréquence de l'impulsion, et/ou le niveau d'énergie sont choisis pour permettre la fusion des nano-particules et le remplissage des micro-coupures de manière à rendre la liaison conductrice.

Dans un mode préféré de réalisation, le procédé de fabrication selon l'invention comporte une étape de masquage des liaisons qui ne doivent pas faire l'objet de ladite étape de frittage de manière à rester non conductrices.

Les liaisons devant être protégées du frittage afin de demeurer non conductrices peuvent être masquées par un masque plastique ou métallique.

Dans un mode particulier de réalisation, le procédé de fabrication selon l'invention comporte une étape de laminage au cours de laquelle on fait fondre une couche de matière plastique déposée sur le substrat en contact avec lesdites liaisons.

Cette couche de matière plastique peut avoir une épaisseur de l'ordre d'une dizaine de micromètres. La matière est choisie pour fondre efficacement pendant l'étape de laminage de manière à remplir les micro-coupures des liaisons devant demeurer non-conductrices, les autres liaisons ayant déjà été rendues conductrices au cours de l'étape de frittage antérieure à cette étape de laminage.

Selon un exemple non couvert par la portée des revendications, il est proposé un composant électrique configurable comportant un motif imprimé avec une nano-encre non conductrice sur un substrat, le motif comportant au moins une micro-coupure.

Selon un exemple non couvert par la portée des revendications, il est proposé un composant électrique comportant un motif imprimé avec une nano-encre non conductrice sur un substrat, ce motif comportant au moins une micro-coupure, une partie dudit motif ayant été rendue conductrice par frittage.

Selon un exemple non couvert par la portée des revendications, il est proposé une antenne à capacité configurable, cette antenne étant reliée à un réseau comportant au moins deux condensateurs en plaques, chaque plaque étant reliée au réseau par une liaison non-conductrice imprimée avec une nano-encre, la liaison étant interrompue par au moins une micro-coupure.

Selon un exemple non couvert par la portée des revendications, il est proposé une antenne reliée à un réseau comportant au moins deux condensateurs en plaques, chaque plaque étant reliée au réseau par une liaison non-conductrice imprimée avec une encre à base de particules conductrices, au moins une de ces liaisons étant interrompue par au moins une micro-coupure.

Selon un exemple non couvert par la portée des revendications, il est proposé une antenne reliée à un réseau comportant au moins deux condensateurs en plaques, chaque plaque étant reliée au réseau par une liaison non-conductrice imprimée avec une nano-encre, au moins une de ces liaisons étant interrompue par au moins une micro-coupure, au moins une desdites liaisons ayant été rendue conductrice par frittage.

Selon un exemple non couvert par la portée des revendications, il est proposé une étiquette RFID comportant une telle antenne et un microcircuit connecté électriquement à ladite antenne.

Selon un exemple non couvert par la portée des revendications, il est proposé un procédé de fabrication d'un document électronique comportant les étapes de fabrication d'une antenne sur un substrat, d'assemblage d'une couche en matière plastique selon le procédé de la revendication, d'usinage de la couche obtenue de sorte à rendre accessible les extrémités de l'antenne, et de connexion électrique du microcircuit à l'antenne.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- la figure 1 représente une antenne configurable conforme à un premier mode particulier de réalisation ;
- la figure 2 représente une antenne configurable conforme à un deuxième mode particulier de réalisation ;
- la figure 3 représente les principales étapes d'un procédé de fabrication selon l'invention ;
- la figure 4 représente en détails une vue en coupe de la liaison imprimée de l'antenne de la figure 2 ;
- la figure 5 représente la liaison imprimée de la figure 3 après une étape de frittage ; et
- les figures 6A et 6B représentent une liaison non-conductrice et une liaison conductrice, respectivement, de l'antenne de la figure 2 après une étape de laminage avec une couche isolante, comme par exemple un plastique de type PET.

### Description détaillée d'un premier mode de réalisation

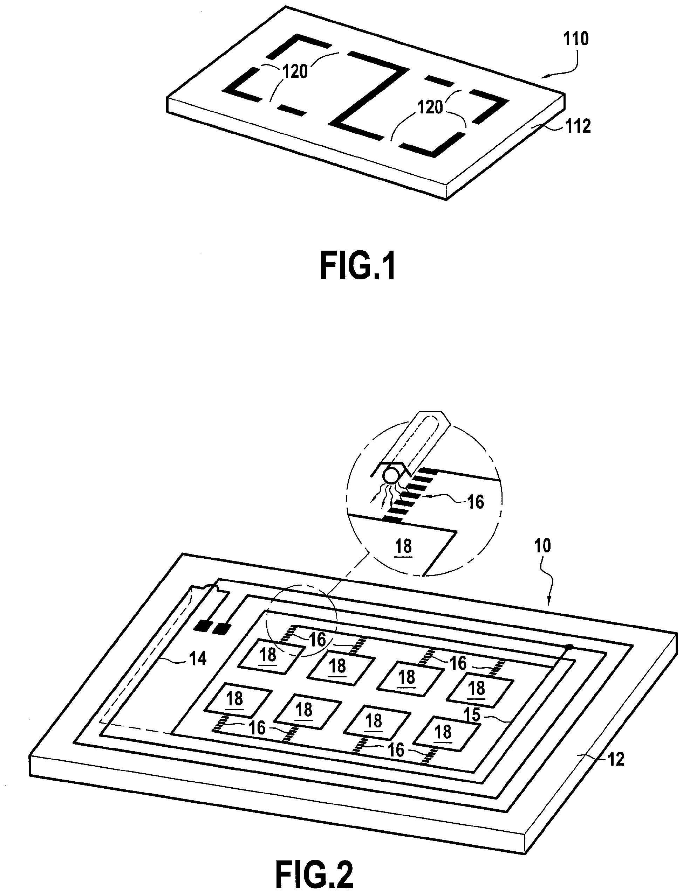

La figure 1 représente une antenne 110 configurable selon un exemple.

Cette antenne 110 comporte un motif, tel qu'un ruban imprimé avec une nano-encre initialement non conductrice, au dépôt, sur un substrat 112.

Conformément à cet exemple, le motif comporte des micro coupures 120.

Tout ou partie de l'antenne 110 peut subir une opération de frittage de manière à assurer le frittage des nanoparticules en chassant le matériau porteur, non conducteur. L'opération de frittage est aussi optimisée de sorte à modifier l'état et faire fondre les nano-particules contenues dans l'encre, au moins dans les parties aux interfaces de part et d'autre de chaque micro-coupure 120, pour remplir au moins partiellement les micro coupures 120 et rendre ces parties de motif conductrices. Les autres parties du motif qui doivent rester non conductrices sont préservées de l'opération de frittage par un masque.

On peut ainsi, à partir d'un substrat standard comportant le motif, faire varier la longueur électrique de l'antenne et obtenir des antennes UHF configurables en fréquence soit par exemple à 902MHz pour le marché américain et des antennes UHF à 860 MHz pour le marché européen (antenne électriquement plus longue).

### Description détaillée d'un deuxième mode de réalisation

La figure 2 représente une antenne à capacité configurable 10 conforme à un mode particulier de réalisation selon un autre exemple.

Cette antenne comporte un certain nombre de spires 14 sur un substrat 12. Conformément à cet exemple, l'antenne est reliée électriquement à un réseau 15 de condensateurs en plaques 18, chaque plaque 18 étant reliée au réseau 15 par des liaisons 16 imprimée avec une nano-encre.

Dans le mode de réalisation décrit ici, le substrat 12 est un PVC de température de fusion de l'ordre de 80°C.

Dans le mode de réalisation décrit ici, on utilise une nano-encre comportant des nanoparticules d'argent, de température de fusion approximativement égale à 960°C.

La capacité Cₐ de l'antenne 10 est ajustée en choisissant les plaques 18 qui doivent être reliées électriquement au réseau 15 et les plaques 18 qui doivent être isolées électriquement du réseau 15.

A cet effet, on peut choisir pour chaque liaison 16 entre une plaque 18 et le réseau 15, si cette liaison 16 doit être électriquement conductrice ou non.

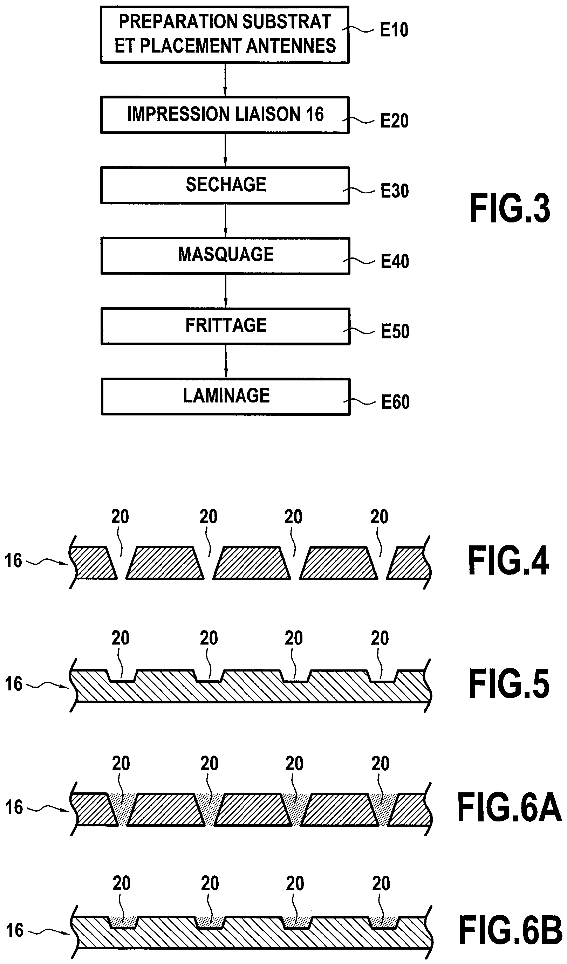

La figure 3 représente sous forme d'organigramme les principales étapes d'un procédé de fabrication d'antenne conforme à un mode particulier de réalisation de l'invention.

Au cours d'une étape E10 on prépare le substrat 12 et on y dispose, par exemple par sérigraphie, les spires d'antenne 14, les plaques conductrices 18 et le réseau 15.

Au cours d'une étape E20, on imprime les liaisons 16 entre les plaques conductrices 18 et le réseau 15 avec une nano-encre. Dans le mode de réalisation décrit ici, et comme représenté à la figure 4, les liaisons 16 comportent des micro-coupures 20.

Dans le mode de réalisation décrit ici, la taille de ces micro-coupures présentent une largeur comprise entre 10µm et 50µm. Ces valeurs peuvent varier selon la précision de l'impression jet d'encre et selon les moyens de frittage permettant de commencer le changement de phase des nanoparticules pour qu'elles remplissent les microcoupures. La limite basse de cette largeur est fixée par la précision d'impression de la machine jet d'encre et la limite haute est donnée par la capacité de frittage par flash sans détériorer la matière.

Par conséquent, à l'issue de l'étape E20 d'impression, les liaisons 16 sont toutes non-conductrices.

Dans l'exemple de réalisation décrit ici, le procédé selon l'invention comporte une étape E30 de séchage afin de stabiliser la nano encre. La température de cette étape de séchage est réglée afin juste d'assurer une stabilité des pistes imprimées sans modifier l'état des nano particules comprises dans la nano-encre de sorte que les liaisons 16 sont encore toutes non-conductrices à l'issue de l'étape de séchage.

Les étapes E10 à E30 constituent les principales étapes d'un procédé de fabrication d'une antenne à capacité configurable conforme à un mode particulier de réalisation de l'invention.

On place ensuite à l'étape E40 un masque sur les liaisons 16 que l'on souhaite garder non conductrices. Ce masque peut-être plastique ou métallique.

De manière à fixer la capacité de l'antenne, on expose, au cours d'une étape E50, les liaisons 16 que l'on souhaite rendre conductrices à une étape de frittage de manière à relier électriquement certaines plaques conductrices 18 au réseau 15.

Dans le mode de réalisation décrit ici, l'étape de frittage s'effectue pendant une durée comprise entre 500ms et 800ms, à une température comprise entre 850°C et 900°C. Le nombre de ces impulsions doit s'adapter aussi à la nature de l'encre utilisée (taille et matière des nanoparticules, par exemple en Or, Cuivre ou Argent) et la nature du substrat.

L'effet de cette étape de frittage est dans un premier temps d'assurer le frittage/la conductivité de chaque piste imprimée à base des nano-encres et dans un deuxième temps (en réglant le nombre, la durée et la puissance des impulsions photoniques) de modifier l'état et de faire fondre les nano-particules contenues dans la nano-encre, de manière à boucher au moins partiellement les micro-coupures 20 et rendre les liaisons 16 concernées conductrices. Le résultat de cette étape de frittage est représenté à la figure 5.

La durée de l'étape de frittage E50 est suffisamment courte pour ne pas endommager le substrat 12 de l'antenne.

Dans le mode de réalisation décrit ici, l'étape E50 de frittage est suivie par un étape E60 de laminage au cours de laquelle on dépose une couche de film plastique sur le réseau 15, cette couche de film plastique étant portée au moins à une température Tg de l'ordre de 80, voire 150°C, suffisante pour la faire fondre pendant le laminage.

A cette température, la nano-encre reste suffisamment stable pour ne pas changer d'état et le film plastique fondu peut alors couler et remplir les microcoupures, garantissant ainsi la non-conductivité électrique de la liaison. Aux figures 6A et 6B on a représenté respectivement une liaison 16 non-conductrice et une liaison 16 conductrice à l'issue de cette étape de laminage : les micro-coupures 20 de la liaison 16 non conductrice de la figure 6A sont remplies de la couche de film plastique fondu.

En revanche, en ce qui concerne la liaison conductrice 16 de la figure 6B, la matière plastique vient recouvrir l'encre à nanoparticules conductrice déposée dans les micro-coupures 20 pendant l'opération de frittage.

Un exemple non couvert par la portée des revendications concerne également un document électronique comportant un substrat sur lequel le circuit d'antenne est réalisé selon le procédé décrit précédemment. Ce document électronique est par exemple un passeport ou une carte de format ID-1, tel que spécifié selon la norme ISO/IEC 7816 ; le format ID-1 désigne une forme globalement rectangulaire de 54 mm x 85.6 mm ; l'épaisseur est classiquement de l'ordre de 760 microns. La carte comporte un microcircuit intégré, qui est capable, à l'aide de l'antenne à laquelle il est électriquement relié, de recevoir et de répondre aux requêtes radio émises depuis un terminal distant.

L'invention s'applique à tous les types de documents électroniques RFID, notamment ceux conformes à la norme ISO14443 et/ou N FC.

La carte est réalisée par un assemblage de couches, dont une des couches est formée par le substrat accueillant l'antenne et le film plastique le recouvrant, l'ensemble étant assemblé avec d'autres couches par une étape de laminage à chaud. Une étape d'usinage de la carte obtenue est réalisée de sorte à rendre accessible les extrémités de l'antenne, et ainsi de pouvoir connecter électriquement le microcircuit à l'antenne.

L'invention s'applique à tout composant électronique réalisé au moins partiellement avec une encre à nano-particules. L'invention s'applique notamment à des composants réalisés avec des pistes ou des motifs de matériaux initialement conducteurs, tels que de la pâte d'argent sérigraphiée, ces pistes ou motifs étant espacés les uns des autres d'un intervalle supérieur à la taille des microcoupures. Le dépôt d'une nano-encre avec microcoupure entre les matériaux conducteurs permet d'obtenir des composants configurables selon l'invention.

## Revendications

1. Procédé de fabrication d'un composant électrique configurable comportant une étape d'impression d'un motif sur un substrat (112, 12) avec une nano-encre à base de nanoparticules conductrices, la nano-encre étant non conductrice initialement, et ledit motif étant interrompu par au moins une micro-coupure (120, 20),
**caractérisé en ce qu'**il comporte une étape (E50) de frittage d'au moins une partie dudit motif de manière à rendre cette partie conductrice, ladite étape (E50) de frittage permettant de modifier l'état des nanoparticules comprises dans ladite nano-encre de manière à remplir au moins partiellement ladite au moins une micro-coupure,
et ladite au moins une micro-coupure présente une largeur comprise entre 10µm et 50µm.

2. Procédé de fabrication d'un composant électrique configurable selon la revendication 1, dans lequel ledit composant est une antenne à capacité configurable, ce procédé comportant :
- une étape (E10) de placement sur ledit substrat (12) d'une antenne, d'un réseau (15) relié à ladite antenne, et d'au moins deux condensateurs en plaques (18) ; et
- ladite étape d'impression du motif comportant l'impression d'une liaison entre ladite plaque et ledit réseau, ladite liaison comportant au moins ladite micro-coupure.

3. Procédé de fabrication d'une antenne à partir d'une antenne à capacité configurable obtenue selon le procédé de la revendication 2, comportant une étape (E50) de frittage d'au moins une desdites liaisons de manière à la rendre conductrice.

4. Procédé de fabrication selon l'une quelconque des revendications 1 à 3, **caractérisé en ce qu'**il comporte une étape (E30) de séchage pour stabiliser ladite nano-encre.

5. Procédé de fabrication selon l'une quelconque des revendications 1 à 4 **caractérisé en ce qu'**il comporte une étape (E40) de masquage des parties du motif qui ne doivent pas faire l'objet de ladite étape de frittage (E50) de manière à rester non conductrices.

6. Procédé de fabrication selon l'une des revendications 1 à 5 **caractérisé en ce qu'**il comporte une étape (E60) de laminage au cours de laquelle on fait fondre une couche de matière plastique déposée sur ledit substrat en contact avec ledit motif.

## Patentansprüche

1. Verfahren zur Herstellung einer konfigurierbaren elektrischen Komponente, umfassend einen Schritt des Druckens eines Musters auf ein Substrat (112, 12) mit einer Nanotinte auf Basis von leitenden Nanopartikeln, wobei die Nanotinte anfänglich nicht leitend ist, und wobei das Muster durch mindestens eine Mikrounterbrechung (120, 20) unterbrochen wird,
**dadurch gekennzeichnet, dass** es einen Schritt (E50) des Sinterns mindestens eines Teils des Musters umfasst, so dass dieser Teil leitend gemacht wird, wobei der Schritt (E50) des Sinterns es ermöglicht, den Zustand der in der Nanotinte enthaltenen Nanopartikel zu ändern, so dass sie die mindestens eine Mikrounterbrechung mindestens teilweise füllen,
und wobei die mindestens eine Mikrounterbrechung eine Breite zwischen 10 um und 50 um aufweist.

2. Verfahren zur Herstellung einer konfigurierbaren elektrischen Komponente nach Anspruch 1, wobei die Komponente eine Antenne mit konfigurierbarer Kapazität ist, wobei dieses Verfahren umfasst:
- einen Schritt (E10) des Platzierens, auf dem Substrat (12), einer Antenne, eines mit der Antenne verbundenen Netzwerks (15) und von mindestens zwei Kondensatoren aus Platten (18); und
- wobei der Schritt des Druckens des Musters das Drucken einer Verbindung zwischen der Platte und dem Netzwerk umfasst, wobei die Verbindung mindestens die Mikrounterbrechung umfasst.

3. Verfahren zur Herstellung einer Antenne ausgehend von einer Antenne mit konfigurierbarer Kapazität, die nach dem Verfahren des Anspruchs 2 erhalten wird, umfassend einen Schritt (E50) des Sinterns mindestens einer der Verbindungen, so dass sie leitend gemacht wird.

4. Verfahren zur Herstellung nach einem der Ansprüche 1 bis 3, **dadurch gekennzeichnet, dass** es einen Schritt (E30) des Trocknens umfasst, um die Nanotinte zu stabilisieren.

5. Verfahren zur Herstellung nach einem der Ansprüche 1 bis 4, **dadurch gekennzeichnet, dass** es einen Schritt (E40) des Maskierens der Teile des Musters umfasst, die nicht Gegenstand des Schritts des Sinterns (E50) sein dürfen, so dass sie nicht leitend bleiben.

6. Verfahren zur Herstellung nach einem der Ansprüche 1 bis 5, **dadurch gekennzeichnet, dass** es einen Schritt (E60) des Laminierens umfasst, bei dem man eine Schicht aus Kunststoff, die auf das Substrat in Kontakt mit dem Muster aufgebracht wird, schmelzen lässt.

## Claims

1. Method for manufacturing a configurable electrical component comprising a step of printing a pattern on a substrate (112, 12) with a nano-ink based on conductive nanoparticles, the nano-ink initially being nonconductive, and said pattern being interrupted by at least one micro-break (120, 20),
**characterized in that** it comprises a step (E50) of sintering at least part of said pattern so as to make that part conductive, said sintering step (E50) making it possible to modify the state of the nanoparticles contained in said nano-ink so as to at least partially fill said at least one micro-break,
and said at least one micro-break has a width of between 10 um and 50 µm.

2. Method for manufacturing a configurable electrical component according to Claim 1, wherein said component is a configurable-capacitance antenna, this method comprising:
- a step (E10) of placing, on said substrate (12), an antenna, a network (15) connected to said antenna, and at least two plate capacitors (18); and
- said step of printing the pattern comprising printing a connection between said plate and said network, said connection comprising at least said micro-break.

3. Method for manufacturing an antenna from a configurable-capacitance antenna obtained according to the method of Claim 2, comprising a step (E50) of sintering at least one of said connections so as to make it conductive.

4. Manufacturing method according to any one of Claims 1 to 3, **characterized in that** it comprises a drying step (E30) for stabilizing said nano-ink.

5. Manufacturing method according to any one of Claims 1 to 4, **characterized in that** it comprises a step (E40) of masking the parts of the pattern which must not be subjected to said sintering step (E50) so as to remain nonconductive.

6. Manufacturing method according to one of Claims 1 to 5, **characterized in that** it comprises a laminating step (E60) during which a layer of plastic deposited on said substrate in contact with said pattern is melted.
